# EUROPEAN PATENT APPLICATION

(11) **EP 4 576 123 A1**
(43) Date of publication of application: **25.06.2025**
(21) Application number: 24222226.3
(22) Date of filing: 20.12.2024
(51) Int. Cl.: H01B 1/24

(54) **CONDUCTIVE PASTE AND SOLAR CELL MODULE INCLUDING THE SAME AND MANUFACTURING METHOD THEREOF**

(30) Priority: 22.12.2023 TW 112150361
(71) Applicant: Industrial Technology Research Institute, 310401 Hsinchu (TW)
(72) Inventor: Yu, Sheng-Min, 324 Taoyuan City (TW); Cho, An-Chi, 404 Taichung City (TW)
(74) Representative: Kurig, Thomas

(57) **Abstract**

Provided is a conductive paste (30, 150) including 30 wt% to 90 wt% of a conductive particle, 0.1 wt% to 10 wt% of a binder, 0.1 wt% to 2 wt% of an organic amine, and 10 wt% to 50 wt% of a solvent. A solar cell module (100) and a manufacturing method thereof are also provided.

## Description

### BACKGROUND

### Technical Field

The disclosure relates to a conductive paste, a solar cell module and a manufacturing method thereof.

### Description of Related Art

In recent years, due to the advantages of organic and inorganic metal halide perovskite materials, such as high photoelectric conversion efficiency and the ability to be stacked with silicon crystal materials, research and technological development in applying these materials to solar cells has been rapidly advancing. Furthermore, in the manufacturing process of solar cell modules, multiple scribing processes are commonly employed to achieve interconnection functionality between components. However, the aforementioned scribing processes, such as laser scribing, are prone to causing decomposition of perovskite materials, thereby resulting in material defects. Consequently, this adversely affects the lifespan of solar cell modules. Therefore, there is an urgent need for a novel interconnection material and method.

### SUMMARY

The disclosure provides a conductive paste, a solar cell module including the same, and a manufacturing method thereof, capable of increasing the service life of the solar cell module and reduce process steps.

An embodiment of the disclosure provides a conductive paste, including 30 wt% to 90 wt% of a conductive particle, 0.1 wt% to 10 wt% of a binder, 0.1 wt% to 2 wt% of an organic amine, and 10 wt% to 50 wt% of a solvent.

An embodiment of the disclosure provides a solar cell module, including a first solar cell, a second solar cell, and a conductive paste layer. The first solar cell includes a first perovskite layer. The second solar cell includes a second perovskite layer. The conductive paste layer is disposed between the first solar cell and the second solar cell. The conductive paste layer is composed of the conductive paste. The conductive paste layer includes a conductive portion and at least two insulating portions. The first solar cell is electrically connected to the second solar cell through the conductive portion, and the first perovskite layer is electrically insulated from the second perovskite layer through the at least two insulating portions.

An embodiment of the disclosure provides a manufacturing method of a solar cell module, including the followings. A substrate is provided. A first patterned conductive layer is formed on the substrate, wherein the first patterned conductive layer has an opening. A perovskite layer is formed on the substrate, wherein a part of the perovskite layer is filled in the opening. The conductive paste is formed on the perovskite layer, wherein an orthographic projection of the conductive paste on the substrate overlaps an orthographic projection of the opening on the substrate. An etching reaction is performed with the conductive paste and the underlying perovskite layer to form a 2D perovskite layer and a conductive paste layer, so that the conductive paste layer is electrically connected to the first patterned conductive layer and is electrically isolated from the perovskite layer.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate example embodiments of the disclosure and, together with the description, serve to explain the principles of the disclosure.
FIG. 1A to FIG. 1G are schematic cross-sectional diagrams of a manufacturing method of a solar cell module according to an embodiment of the disclosure.
FIG. 1H is an enlarged schematic diagram of a partial region of FIG. 1E.
FIG. 2A, FIG. 2B, and FIG. 2C are resistance test structure diagrams of various conductive pastes.
FIG. 3 is a schematic diagram of resistance test results of various conductive pastes relative to addition amounts of different organic amines.
FIG. 4 is a schematic diagram of resistance test results for the conductive paste of the disclosure at various heating temperatures.
FIG. 5A to FIG. 5B illustrate various lateral leakage current test structures for different conductive pastes.

### DESCRIPTION OF THE EMBODIMENTS

The following disclosure in this specification provides different embodiments or examples for implementing different features of various embodiments of the disclosure. The following disclosures in this specification describe specific examples of each component and its arrangement in order to simplify the explanation. Of course, these specific examples are not intended to limit the disclosure. In addition, repeated reference symbols and/or words may be used in different examples in the description of the disclosure. These repeated symbols or words are for the purpose of simplicity and clarity, and are not used to limit the relationship between the various embodiments and/or the described appearance structures. Furthermore, if the following disclosure content in this specification describes forming a first feature on or above a second feature, it means that it includes an embodiment in which the first feature formed is in direct contact with the second feature, and it also includes an embodiment in which additional features may be formed between the first feature and the second feature, so that the first feature and the second feature may not be in direct contact.

The conductive paste disclosed herein possesses the advantage of being able to simultaneously achieve electrical connection and electrical insulation through an etching reaction with perovskite materials. Furthermore, when applied to solar cell modules, it can effectively increase their service life and reduce manufacturing process steps. To elucidate the purpose, characteristics, and advantages of the conductive paste more clearly and comprehensibly, a detailed explanation is provided below using an embodiment of a solar cell module 100. However, this embodiment is not intended to limit the scope of the conductive paste disclosed herein.

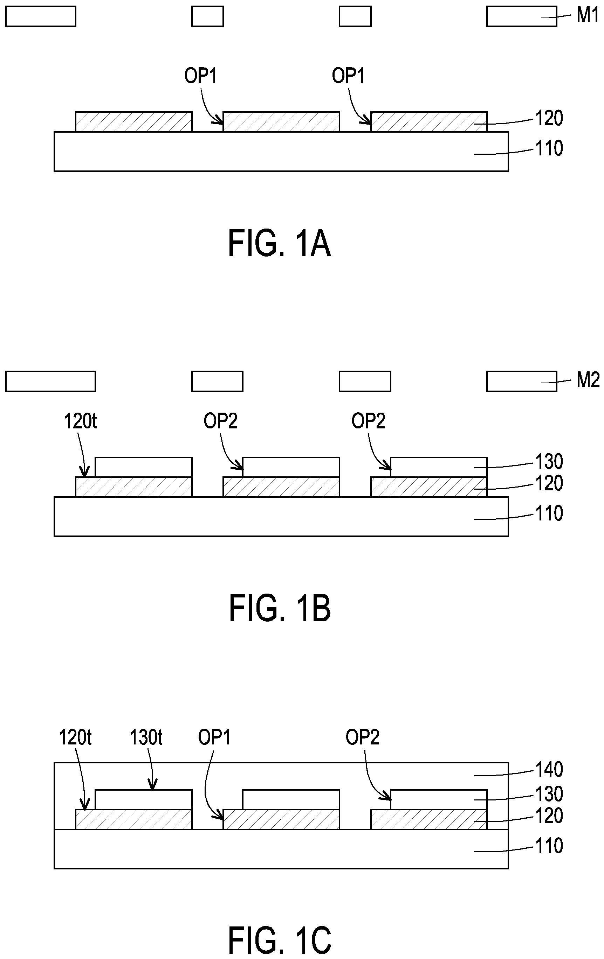

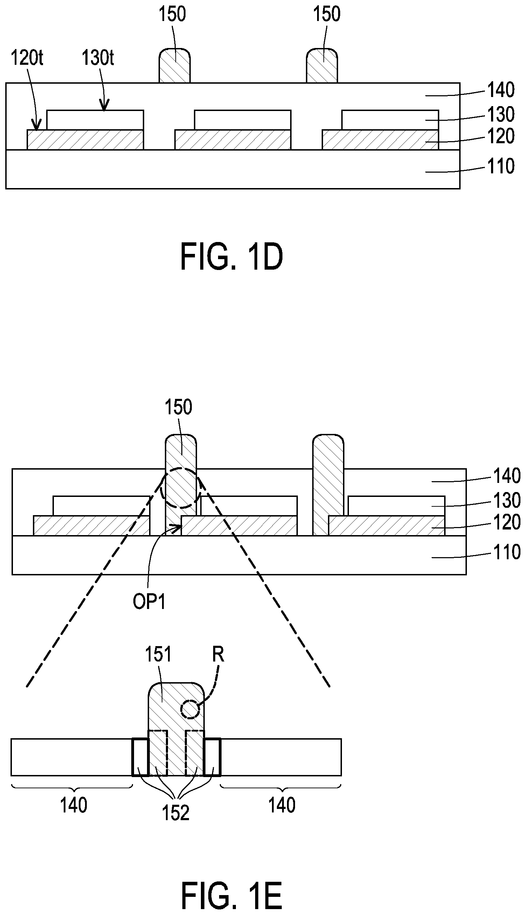

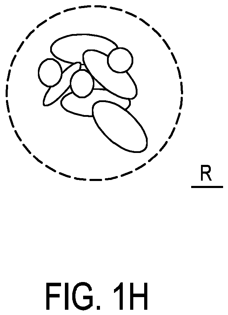

FIG. 1A to FIG. 1G are schematic cross-sectional diagrams of a manufacturing method of a solar cell module 100 according to an embodiment of the disclosure. FIG. 1H is an enlarged schematic diagram of a partial region of FIG. 1E. Please refer to FIG. 1A. First, a patterned conductive layer 120 is formed on a substrate 110. The material of the substrate 110 can be glass, and the material of the patterned conductive layer 120 can be transparent conductive oxide (TCO, e.g., indium tin oxide (ITO) or Fluorine-doped tin oxide (FTO)). In this embodiment, the patterned conductive layer 120 is formed on the substrate 110 by sputtering through a mask M1. Consequently, its pattern can be formed directly corresponding to the mask M1, resulting in the presence of openings OP1. As a result, one scribing process (such as a laser process) can be omitted.

Referring to FIG. 1B, a patterned electron transport layer 130 is formed on the patterned conductive layer 120, where the material of the patterned electron transport layer 130 may be TiO₂ or SnO₂. In this embodiment, the patterned electron transport layer 130 is formed on the patterned conductive layer 120 by sputtering through a mask M2, and its pattern can be formed directly corresponding to the mask M2. Herein, the mask M2 may differ from the mask M1, thereby producing distinct patterns. For instance, as illustrated in FIG. 1B, the dimensions of each portion of the patterned electron transport layer 130 may be smaller than those of the underlying patterned conductive layer 120. Furthermore, the openings OP1 formed by the patterned conductive layer 120 are smaller than openings OP2 formed by the patterned electron transport layer 130. Consequently, the patterned electron transport layer 130 exposes a portion of a top surface 120t of the patterned conductive layer 120.

Referring to FIG. 1C, a perovskite layer 140 is formed on the substrate 110, so that part of the perovskite layer 140 is filled in the openings OP1 of the patterned conductive layer 120 and the openings OP2 of the patterned electron transport layer 130. The perovskite layer 140 may be made of AMX₃ material coated on the substrate 110, where M represents Ge²⁺, Sn²⁺, or Pb²⁺; A represents methylammonium, ethylammonium, or formamidinium; X represents F⁻, Cl⁻, Br⁻ or I⁻. In this embodiment, the perovskite layer 140 also covers a top surface 130t of the patterned electron transport layer 130 and the top surface 120t of the patterned conductive layer 120 exposed by the patterned electron transport layer 130.

Referring to FIG. 1C and FIG. 1D, a conductive paste 150 is formed on the perovskite layer 140. Then, referring to FIG. 1D and FIG. 1E, the conductive paste 150 contacts the underlying perovskite layer 140 to perform an etching reaction and form a 2D perovskite layer 152 so that the conductive paste 150 is electrically connected to the patterned conductive layer 120 and electrically insulated from the surrounding perovskite layer 140. In some embodiments, the conductive paste 150 contacts the underlying perovskite layer 140 to perform an etching reaction and form a 2D perovskite layer and perovskite layer hybrid structure 152, which can also allow the conductive paste 150 to be electrically connected to the patterned conductive layer 120 and electrically insulated from the surrounding perovskite layer 140.

The conductive paste 150 includes 30wt% to 90wt% of conductive particle (such as, 30 wt%, 40 wt%, 50 wt%, 60 wt %, 70 wt%, 80 wt%, 90 wt%, or an appropriate value within the range of greater than or equal to 30 wt% and less than or equal to 90 wt%), 0.1 wt% to 10 wt% of binder (such as, 0.1 wt%, 0.5 wt%, 1 wt%, 3 wt %, 5 wt%, 7 wt%, 10wt%, or an appropriate value within the range of greater than or equal to 0.1 wt% and less than or equal to 10 wt%), 0.1 wt% to 2 wt% of organic amine(such as, 0.1 wt%, 0.2 wt%, 0.3 wt%, 0.5 wt %, 0.7 wt%, 1 wt%, 1.2 wt%, 1.5 wt%, 1.7 wt%, 2 wt%, or an appropriate value within the range of greater than 0.1 wt% and less than or equal to 2 wt%), and 10 wt% to 50 wt% of solvent(such as, 10 wt%, 15 wt%, 20 wt%, 25 wt %, 30 wt%, 40 wt%, 50 wt%, or an appropriate value within the range of greater than or equal to 10 wt% and less than or equal to 50 wt%), so as to enable the conductive paste to achieve the purpose of vertical conduction and lateral insulation, so that the solar cell module 100 has excellent photovoltaic conversion efficiency.

In some embodiments, the conductive paste 150 is formed at a specific position on the perovskite layer 140 through a printing process. The conductive paste 150 undergoes a dissolution reaction with the perovskite layer 140 in direct contact, subsequently replacing a portion of the perovskite layer 140 under the conductive paste 150. Furthermore, the conductive particles within the conductive paste form a conductive portion 151 of the conductive paste layer 150, thereby achieving vertical conduction. In this way, the subsequent scribing process may be omitted, thereby reducing the manufacturing steps. This effectively decreases the probability of defects occurring in the perovskite material during the scribing process, thus increasing the service life of the solar cell module 100. For example, when the scribing process involves laser process, its high energy promotes the decomposition of perovskite materials. The decomposed perovskite releases free halogen, causing a chain reaction that accelerates aging and creates defects, thereby affecting the service life of the solar cell module.

In some embodiments, the orthographic projection of the formation position (vertical conduction position) of the conductive paste 150 on the substrate 110 overlaps with the orthographic projection of the opening OP1 on the substrate 110, so that the conductive paste layer 150 penetrating the perovskite layer 140 directly contacts the patterned conductive layer 120. On the other hand, the organic amine in the conductive paste 150 also laterally diffuses to the perovskite layer 140 and react it, thereby forming an insulating portion in the conductive paste layer 150, that is, the 2D perovskite layer 152 or the 2D perovskite layer and perovskite layer hybrid structure 152 to achieve lateral insulation.

In some embodiments, the boiling point range of the organic amine is greater than or equal to 50°C and less than or equal to 180°C, so that the organic amine can reliably perform an etching reaction with the perovskite layer 140 and be removed after the etching reaction. For example, when a heating process is performed during the reaction between the conductive paste 150 and the perovskite layer 140, the organic amine with a too low boiling point is easily volatilized during the reaction, resulting in poor etching effect. On the other hand, when the conductive paste 150 reacts with the perovskite layer 140 and then undergoes a drying process, the organic amine with a too high boiling point is detrimental to its removal.

In some embodiments, since the organic amine in the conductive paste 150 diffuses in all directions and reacts during the heating process (both vertical paths and horizontal paths), there may be no interface between the conductive portion 151 of the conductive paste layer 150 and the insulating portion (the 2D perovskite layer 152 or the 2D perovskite layer and perovskite layer hybrid structure 152) (thus the junction between the conductive portion 151 and the insulating portion (the 2D perovskite layer 152 or the 2D perovskite layer and perovskite layer hybrid structure 152) is shown by dotted lines in FIG. 1E).

In some embodiments, the conductive particles extend vertically downward through the perovskite layer 140. Consequently, even if trace amount insulating portions (the 2D perovskite layer 152 or the 2D perovskite layer and perovskite layer hybrid structure 152) are formed within the conductive portion 151, vertical conductive pathways can still be established.

In some embodiments, the temperature range of the heating process is greater than or equal to 50°C and less than or equal to 120°C, and the time range of the heating process is greater than or equal to 10 seconds and less than or equal to 1000 seconds.

In some embodiments, the insulating portion is composed of a two-dimensional (2D) wide energy gap perovskite or a hybrid structure of a 2D perovskite layer and a 3D perovskite layer (the energy gap is, for example, 1.8 eV or above). The perovskite layer 140 is composed of a three-dimensional (3D) narrow energy gap perovskite (the energy gap is, for example, between 1.1 eV and 1.7 eV).

In some embodiments, the organic amine includes one or more alkylamines with a main carbon chain of 4 to 8 carbon atoms. For example, the organic amine includes butylamine, pentylamine, hexylamine, heptylamine, octylamine, or a combination of the above, where the boiling point increases with the number of carbon atoms.

In some embodiments, when the material of the perovskite layer 140 is narrow energy gap perovskite methylamino lead iodide (MAPbI₃), and the organic amine in the conductive paste 150 layer is octylamine, the molecules of the octylamine will be exchanged into the crystal lattice of the perovskite material to form a wide energy gap perovskite octylamine lead iodide (OA₂PbI₄). Since octylamine has a long carbon chain molecule, it has a better insulating property. Methylamine lead iodide is dark brown in color with an iodine to lead ratio of 1:3, while octylamine lead iodide is yellow in color with an iodine to lead ratio of 1:4, i.e., narrow energy gap perovskite and wide energy gap perovskite have different colors and composition ratios, and thus can be differentiated from each other and their interfaces with conductive paste layers by SEM electron microscopy.

Similarly, when the material of the perovskite layer 140 is narrow energy gap perovskite methylamino lead iodide (MAPbI₃), and the organic amine in the conductive paste layer 150 is butylamine, the molecules of butylamine will be exchanged into the crystal lattice of the perovskite material to form a wide energy gap perovskite butylamine lead iodide (BA₂PbI₄).

In some embodiments, the wide energy gap perovskite has a moisture-resistant function, so the service life of the solar cell module 100 can be further increased.

In some embodiments, the conductive particles include conductive carbon materials, conductive oxides, metals, or a combination thereof, so as to have better electrical performance.

In some embodiments, the conductive carbon material includes graphite, carbon black, graphene, or a combination thereof, the conductive oxide includes indium tin oxide, indium zinc oxide, or a combination thereof, and the metal includes gold, silver, copper, aluminum, or a combination thereof.

In some embodiments, the metal is a composite structure composed of any one of silver, copper, and aluminum and any one of gold, manganese, and chromium, thereby mitigating the adverse effects of free halogens and achieving a halogen isolation effect.

In some embodiments, the binder includes polyvinyl butyral, ethyl cellulose, methyl cellulose, or a combination thereof.

In some embodiments, the solvent includes polyisopropyl alcohol, ethanol, terpineol or, a combination thereof.

In some embodiments, the manufacturing method of the conductive paste 150 is to stir and disperse suitable materials such as conductive particles, binders, organic amines, and solvents evenly, so as to be directly coated on the perovskite layer 140.

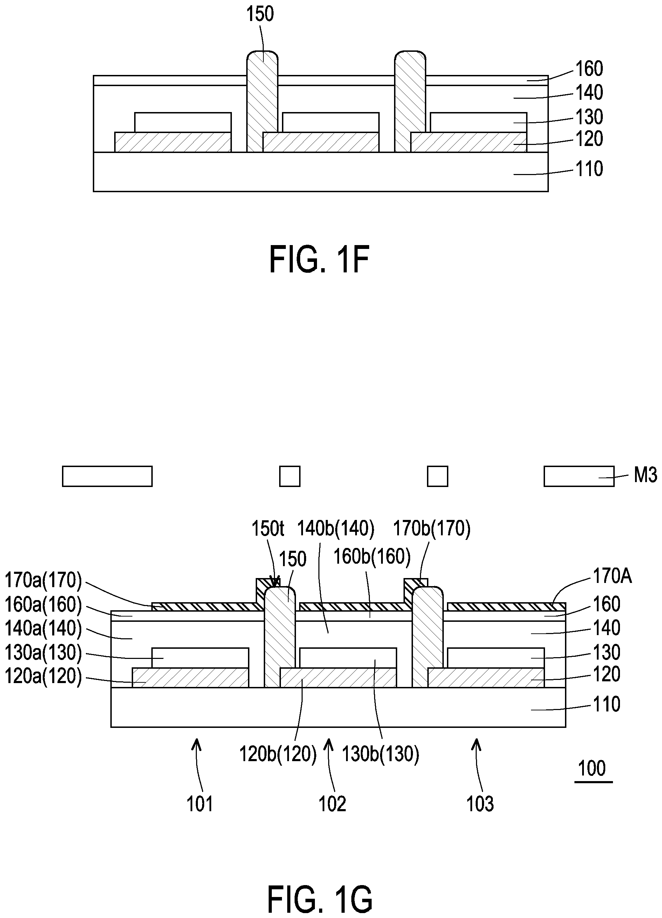

In some embodiments, as shown in FIG. 1G, corresponding to a region R in FIG. 1E, the microstructure of the conductive paste 150 is an irregular agglomeration structure formed by conductive particles, binder, organic amine, and solvent.

Referring to FIG. 1F, a patterned hole transport layer 160 is formed on the perovskite layer 140, where the material of the patterned hole transport layer 160 includes Spiro-MeOTAD, P3HT, NiOₓ, or a combination thereof. In this embodiment, the patterned hole transport layer 160 is coated and formed on the perovskite layer 140 through an inkjet process, so it can be directly placed at the desired position, omitting the subsequent scribing step. In addition, the conductive portion 151 as a vertical conductive path in the conductive paste layer 150 may be formed before the patterned hole transport layer 160.

Referring to FIG. 1G, a patterned conductive layer 170 is formed on the substrate 110 and is electrically connected to the patterned metal layer 120 through the conductive paste layer 150. The material of the patterned conductive layer 170 may be metal. For example, when the patterned conductive layer 170 is made of silver, the direct contact between the silver and the perovskite material will react to form silver halide, which will lead to the decomposition of perovskite, and the silver itself will deteriorate and make the resistance higher. Since the aforementioned defects will cause a lot of loss of electron holes (carrier recombination) at the interface between silver and the perovskite material, the introduction of the conductive paste layer 150 may prevent the patterned conductive layer 170 from directly contacting the perovskite layer 140, which in turn improves the above problem.

In this embodiment, the patterned conductive layer 170 is formed on the patterned substrate 110 by sputtering through a mask M3 (e.g., formed on the side of the conductive paste layer 150 opposite to the patterned conductive layer 120), so its pattern can be formed directly corresponding to the mask M3. In this way, one scribing process may be omitted, and the patterned conductive layer 170 may not be included in the vertical conductive path. That is, the patterned conductive layer 170 is only located on the patterned hole transport layer 160 and does not extend through the perovskite layer 140.

The production of the solar cell module 100 of this embodiment can be substantially completed after the above process. It should be noted that only three solar cells 101, 102, 103 are shown in series connection in FIG. 1G, however, it is possible to have a greater number of solar cells in series connection.

The following illustrates the series connection of the embodiment for the solar cells 101 and 102, and similar configurations and electrical connections may be made between the solar cells 102 and 103 or between other solar cells not shown. As shown in FIG. 1G, the solar cell 101 includes a first portion 120a of the patterned conductive layer 120, a first portion 130a of the patterned electron transport layer 130, a first portion 140a of the perovskite layer 140, a first portion 160a of the patterned hole transport layer 160, and a first portion 170a of the patterned conductive layer 170 that are stacked in sequence. The solar cell 102 includes a second portion 120b of the patterned conductive layer 120, a second portion 130b of the patterned electron transport layer 130, a second portion 140b of the perovskite layer 140, a second portion 160a of the patterned hole transport layer 160, and a second portion 170b of the patterned conductive layer 170 that are stacked in sequence. In this embodiment, the conductive paste layer 150 is disposed between the first solar cell 101 and the second solar cell 102, and the first portion 170a (back electrode) of the patterned conductive layer 170 of the solar cell 101 is disposed on the conductive paste layer 150, and is connected in series with the second portion 120b (front electrode) of the patterned conductive layer 120 of the second solar cell 102 through the conductive portion 151 of the conductive paste layer 150.

In this embodiment, the width of the conductive paste layer 150 is greater than or equal to 10 microns and less than or equal to 500 microns, and the thickness of the conductive paste layer 150 is greater than or equal to 1 micron and less than or equal to 100 microns. In this way, the penetration of the perovskite layer 140 can more effectively reduce the probability that too much of the perovskite layer 140 will be replaced and reduce the photovoltaic conversion efficiency of the solar module 100. The thickness of the conductive paste layer includes an recessed portion that penetrates the perovskite layer 140 and a protruded portion that protrudes out of the top surface of the patterned hole transport layer 160, and the thickness of the protruded portion is greater than the thickness of the recessed portion. It should be noted that, for clarity of illustration, the conductive paste layer 150 and its proportional relationship with other components in the drawings herein are not drawn to scale.

As shown in FIG. 1G, the patterned conductive layer 170 may be conformally formed on the substrate 110. The patterned conductive layer 170 extends from the surface of the perovskite layer 140 through the sidewall of the conductive paste layer 150 to its top surface 150t. Due to the characteristics of the conductive paste layer 150, the top surface 150t of the conductive paste layer 150 is formed with rounded corner, and a portion of the patterned conductive layer 170 (corresponding to a first back electrode) covers the rounded corner, so that the patterned conductive layer 170A extends more easily over the rounded corner than sharp corner, which in turn reduces the probability of a broken wire and short circuit, and further enhances the electrical performance.

The effectiveness of the conductive paste in the embodiment is illustrated in the following experiments and simulations.

### <Comparative example 1>

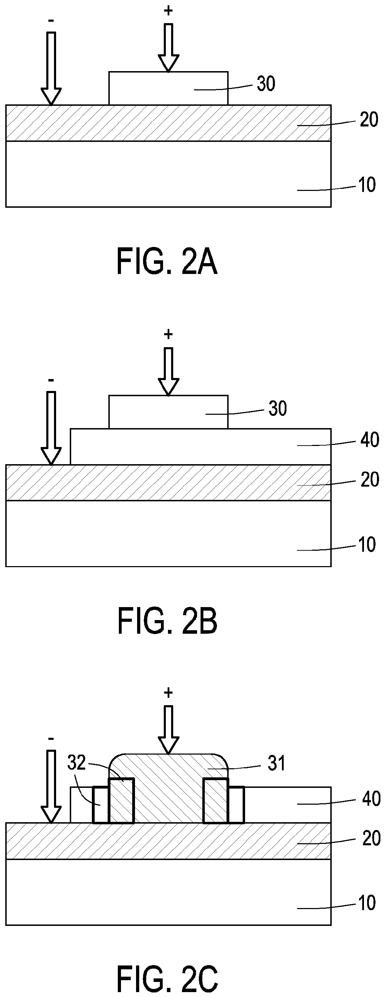

A stacked structure composed of a glass substrate 10, a fluorine-doped tin oxide layer 20, and a conductive paste layer 30 was provided, and then a resistance test was performed with the setup in FIG. 2A. The actual measured resistance value is 16.6 ohm, where the composition of the conductive paste layer 30 is 50wt% graphite, 5wt% polyvinyl butyral, and 45wt% isopropyl alcohol.

### <Comparative example 2>

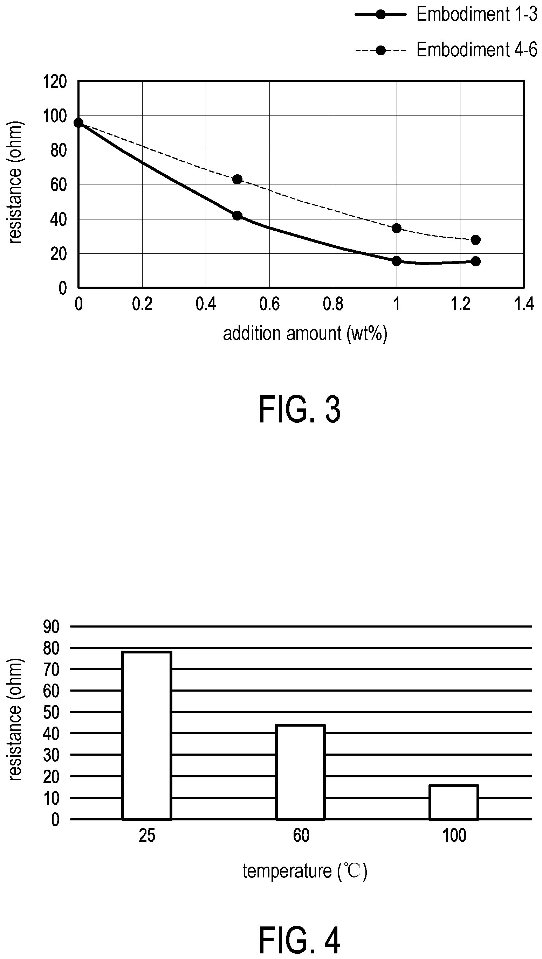

A stacked structure composed of a glass substrate 10, a fluorine-doped tin oxide layer 20, a perovskite layer 40, and a conductive paste layer 30 was provided, and then resistance at two arrows is measured with the setup in FIG. 2B. The actual measured resistance value is 95.7ohm (corresponding to the part where the addition amount is 0wt% in FIG. 3).

### <Embodiments 1-6>

A stacked structure composed of a glass substrate 10, a fluorine-doped tin oxide layer 20, a perovskite layer 40, and a conductive paste layer (including a conductive portion 31 and an insulating portion 32) was provided (formed by heating the conductive paste including organic amine at 100°C to etch the perovskite layer 40), and then a resistance test was performed with the setup in FIG. 2C. The composition of the conductive paste used in the conductive paste layer of Embodiments 1-6 is shown in Table 1, and the actual measured resistance values are shown in FIG. 3. In addition, the conductive paste of Embodiment 5 was used for heating processes at 25°C, 60°C, and 100°C. The actual measured resistance values are shown in FIG. 4, which shows that the resistance value at the process temperature of 100°C is relatively low.

**Table 1**

| | Embodiment 1 | Embodiment 2 | Embodiment 3 | Embodiment 4 | Embodiment 5 | Embodiment 6 |
|---|---|---|---|---|---|---|
| graphite | 50g | 50g | 50g | 50g | 50g | 50g |
| polyvinyl butvral | 5g | 5g | 5g | 5g | 5g | 5g |
| isopropyl alcohol | 45g | 45g | 45g | 45g | 45g | 45g |
| octylamine | 0.5g | 1g | 1.25g | 0 | 0 | 0 |
| butylamine | 0 | 0 | 0 | 0.5g | 1g | 1.25g |

According to the results of Embodiments 1-6 and Comparative Examples 1 and 2, it can be seen that the conductive paste including organic amine can reliably etch through the perovskite layer 40, and the formed conductive portion 31 is electrically connected by direct contact with the underlying fluorine-doped tin oxide layer 20, and thus there is a significant decrease in the resistance value, and a degree of conductivity similar to that of Comparative Example 1 is achieved. In addition, this trend occurs when the organic amine is butylamine or octylamine.

### <Comparative Example 3>

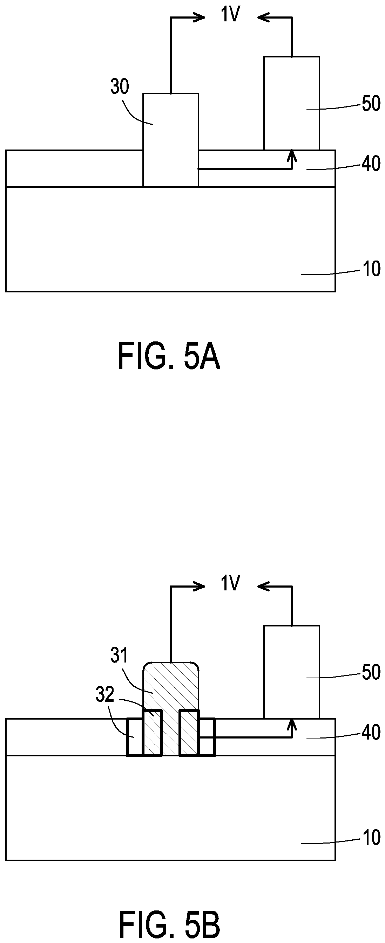

A stacked structure composed of a glass substrate 10, a perovskite layer 40, a conductive paste 30 (carbon glue), and a copper glue 50 (supplier: 3M double-sided conductive copper foil tape, model 1182) was provided, and then a lateral leakage current test was conducted with the setup in FIG. 5A. The actual measured lateral leakage current is 0.004µA.

### <Embodiment 7>

A stacked structure composed of a glass substrate 10, a perovskite layer 40, a conductive paste (including a conductive portion 31 and an insulating portion 32) of Embodiment 5, and a copper paste 50 are provided, and then a lateral leakage current test was conducted with the setup in FIG. 5B. The actual measured lateral leakage current is 0.001µA.

According to the results of Embodiment 7 and Comparative Example 3, it can be seen that the conductive paste of Embodiment 5 has an insulating portion 32, so the lateral leakage current is smaller, the interface impedance is larger, and has better electrical insulation effect.

### < Embodiment 8>

First, the conductive paste used in the solar cell module of Embodiment 8 was produced. Specifically, after the composition in Table 2 was provided, the binder (ethyl cellulose) was added to the solvent (isopropyl alcohol) and stirred to dissolve, then the conductive particles (graphite, carbon black) were added to stir and mix for 2 hours, and then the organic amine (octylamine) was added and stirred for another 10 minutes to obtain the conductive paste.

**Table 2**

| composition | Used weight (g) |
|---|---|
| graphite (G36C-300-85) | 9 |
| carbon black (G34-KE-7900) | 3 |
| ethyl cellulose | 1 |
| isopropyl alcohol | 5 |
| octylamine | 0.2 |

Next, the solar cell module of Embodiment 8 is produced in the following steps.

Step 1: use Coming^{®} EAGLE XG^{®} Glass of 5 cm x 5 cm as the substrate and clean it with alcohol by shaking in an ultrasonic bath, then remove and blow dry the substrate with nitrogen.

Step 2: cover the substrate with a mask, and produce three patterned conductive layers (ITO films) of 5 cm in length and 0.6 cm in width by a sputtering process, with a spacing of 0.5 cm side by side. The resistance of the patterned conductive layer is 10 ohm/sq. The sputtering target composition is In₂O₃ 90 wt% and SnO₂ 10 wt%, the size is three inches in diameter, the sputtering power is 100W, the sputtering atmosphere is Argon 50 sccm and Oxygen 1 sccm, and the coating time is 300 sec. The test piece was taken out after completion.

Step 3: cover the substrate with a mask, and produce three patterned conductive layers (TᵢO₂ films) of 5 cm in length and 0.4 cm in width by a sputtering process, aligned with the right edge of the patterned conductive layer. The sputtering target composition is TᵢO₂ (100wt%), the size is three inches in diameter, the sputtering power is 100W, the sputtering atmosphere is Argon 20 sccm and Oxygen 1 sccm, and the coating time is 300 s. The test piece was taken out after completion.

Step 4: drop 1ml of paste (1.25M FAPbI₃, solvent DMSO) used to form the perovskite layer onto the substrate, using spin-coating at 5000rpm and 200 µl of toluene at the 40th second and let it dry for 5 seconds, then remove the specimen and anneal it on a heating plate at 135°C for 60 minutes.

Step 5: print the conductive paste into three patterns of 5cm in length, 0.1cm in width, and 35 *µ*m in thickness on the perovskite layer, aligned with the left edge of the patterned conductive layer, and place it on a 100°C heating plate for five minutes to etch and ensure the conductive paste is completely dry.

Step 6: take out the substrate and place it in a spin-coating machine, apply a paste (Spiro-MeOTAD) of the patterned hole transport layer and avoid the position of the conductive paste, then spin-coat at 3000 rpm to form a film and leave it at room temperature for 10 minutes to dry.

Step 7: cover the substrate with a mask, and produce two another patterned conductive layers (copper film) of 5 cm in length and 0.8 cm in width by a sputtering process, and align the right edge of the thin film with the right two strips of the conductive paste, then the solar cell module of Embodiment 8 is completed. Under the simulated daylight (AM1.5) environment, the measured open-circuit voltage is 2.12 V, the short-circuit current is 12.32 mA, and the fill factor is 44.5%, indicating that the conductive paste can be effectively used for series connection of components, and that the solar cell module of Embodiment 8 can be operated accordingly.

To sum up, in the disclosure, the conductive paste is formed into the conductive position of the perovskite layer, so that the conductive paste undergoes an etching reaction with the perovskite layer, thereby forming the conductive portion and the insulating portion of the conductive paste layer, and at the same time achieves the functions of electrical connection and electrical insulating. In this way, the subsequent scribing process may be omitted and the number of steps may be reduced to effectively reduce the chance of defects on the perovskite layer in the scribing process, and increase the service life of the solar cell module.

### Reference Sign List

10: glass substrate
20: fluorine-doped tin oxide layer
30, 150: conductive paste layer, conductive paste
31, 151: conductive portion
32: insulating portion
152: 2D perovskite layer, 2D perovskite layer and perovskite layer hybrid structure
40, 140: perovskite layer
50: copper glue
100: solar cell module
101 , 102 , 103: solar cells
110: substrate
120 , 170: patterned conductive layer
120a , 130a , 140a , 160a , 170a: first portion
120b , 130b , 140b , 160b , 170b: second portion
120t , 130t , 150t: top surface
130: patterned electron transport layer
160: patterned hole transport layer
M1 , M2 , M3: mask
OP1 , OP2: opening
R: region

## Claims

1. A conductive paste (30, 150), comprising:
30 wt% to 90 wt% of a conductive particle;
0.1 wt% to 10 wt% of a binder;
0.1 wt% to 2 wt% of an organic amine; and
10 wt% to 50 wt% of a solvent.

2. The conductive paste (30, 150) according to claim 1, wherein a boiling point range of the organic amine is greater than or equal to 50°C and less than or equal to 180°C.

3. The conductive paste (30, 150) according to claim 1, wherein the organic amine comprises one or more alkylamines with a main carbon chain of 4 to 8 carbon atoms.

4. The conductive paste (30, 150) according to claim 1, wherein the conductive particle comprises a conductive carbon material, a conductive oxide, a metal, or a combination thereof.

5. The conductive paste (30, 150) according to claim 4, wherein the conductive carbon material comprises graphite, carbon black, graphene, or a combination thereof.

6. The conductive paste (30, 150) according to claim 4, wherein the conductive oxide comprises indium tin oxide, indium zinc oxide, or a combination thereof.

7. The conductive paste (30, 150) according to claim 4, wherein the metal comprises gold, silver, copper, aluminum, or a combination thereof.

8. The conductive paste (30, 150) according to claim 4, wherein the metal is a composite structure composed of any one of silver, copper, and aluminum and any one of gold, manganese, and chromium.

9. The conductive paste (30, 150) according to claim 1, wherein the binder comprises polyvinyl butyral, ethyl cellulose, methyl cellulose, or a combination thereof.

10. The conductive paste (30, 150) according to claim 1, wherein the solvent comprises polyisopropyl alcohol, ethanol, terpineol, or a combination thereof.

11. A solar cell module (100), comprising:
a first solar cell (101), comprising a first perovskite layer (140a);
a second solar cell (102), comprising a second perovskite layer (140b); and
a conductive paste layer (150), disposed between the first solar cell (101) and the second solar cell (102), wherein the conductive paste layer comprises of the conductive paste (150)according to any one of claims 1 to 10, the conductive paste layer (150) comprises a conductive portion (151) and at least two insulating portions (152), the first solar cell (101) is electrically connected to the second solar cell (102) through the conductive portion (151), and the first perovskite layer (140a) is electrically insulated from the second perovskite layer (140b) through the at least two insulating portions (152).

12. The solar cell module (100) according to claim 11, wherein no interface is between the conductive portion (151) and the at least two insulating portions (152) respectively.

13. The solar cell module (100) according to claim 11, wherein the at least two insulating portions (152) comprise a wide energy gap perovskite crystal with an energy gap of 1.8 eV or above.

14. The solar cell module (100) according to claim 11, wherein the first solar cell (101) comprises a back electrode (170a), the second solar cell (102) comprises a front electrode (120b), the back electrode (170a) is disposed on the first perovskite layer (140a) and the conductive paste layer (150) and is electrically connected to the front electrode (120b) through the conductive portion (151).

15. The solar cell module (100) according to claim 14, wherein a top surface (150t) of the conductive paste layer (150) has a rounded corner, and the back electrode (170a) covers the rounded corner.

16. The solar cell module (100) according to claim 14, wherein the back electrode (170a) does not directly contact the first perovskite layer (140a).

17. The solar cell module (100) according to claim 11, wherein a width of the conductive paste layer (150) is greater than or equal to 10 microns and less than or equal to 2000 microns.

18. The solar cell module (100) according to claim 11, wherein a thickness of the conductive paste layer (150) is greater than or equal to 1 micron and less than or equal to 100 microns.

19. A manufacturing method of a solar cell module (100), comprising:
providing a substrate (110);
forming a first patterned conductive layer (120) on the substrate, wherein the first patterned conductive (120) layer has an opening (OP1);
forming a perovskite layer (140) on the substrate, wherein a part of the perovskite layer (140) is filled in the opening (OP1);
forming the conductive paste (150) according to any one of claims 1 to 10 on the perovskite layer (140), wherein an orthographic projection of the conductive paste (150) on the substrate overlaps an orthographic projection of the opening (OP1) on the substrate (110); and
performing an etching reaction with the conductive paste (150) and the underlying perovskite layer (140) to form a 2D perovskite layer (152) and a conductive paste layer (150), such that the conductive paste layer (150) is electrically connected to the first patterned conductive layer (120) and is electrically isolated from the perovskite layer (140).

20. The manufacturing method of a solar cell module (100) according to claim 19, wherein the etching reaction comprises performing a heating process and a drying process.

21. The manufacturing method of a solar cell module (100) according to claim 19, wherein a temperature range of the heating process is greater than or equal to 50°C and less than or equal to 120°C.

22. The manufacturing method of a solar cell module (100) according to claim 19, wherein a time range of the heating process is greater than or equal to 10 seconds and less than or equal to 1000 seconds.

23. The manufacturing method of a solar cell module (100) according to claim 19, wherein the first patterned conductive layer (120) is formed through a mask (M1).

24. The manufacturing method of a solar cell module according to claim 19 further comprising: after performing the etching reaction, forming a second patterned conductive layer (170) on a side of the conductive paste layer (150) opposite to the first patterned conductive layer (120) through a mask (M3).
